Europäisches Patentamt

European Patent Office

Office européen des brevets

(11) Publication number: **0 347 613**
**A2**

## (12) EUROPEAN PATENT APPLICATION

(21) Application number: **89109662.0**

(51) Int. Cl.⁴: **H01L 23/48** , **H01L 23/56**

(22) Date of filing: **29.05.89**

| | |
|---|---|
| The title of the invention has been amended (Guidelines for Examination in the EPO, A-III, 7.3). | (71) Applicant: **MITSUBISHI DENKI KABUSHIKI KAISHA** **2-3, Marunouchi 2-chome Chiyoda-ku** **Tokyo 100(JP)** |
| (30) Priority: **03.06.88 JP 138006/88** | (72) Inventor: **Tokunoh, Futoshi c/o Mitsubishi Denki K.K.** |
| (43) Date of publication of application: **27.12.89 Bulletin 89/52** | **Kitaitami Seisakusho 1, Mizuhara 4-chome Itami-shi Hyogo(JP)** |
| (84) Designated Contracting States: **CH DE GB LI** | (74) Representative: **Sajda, Wolf E., Dipl.-Phys. et al** **MEISSNER, BOLTE & PARTNER** **Widenmayerstrasse 48 Postfach 86 06 24** **D-8000 München 86(DE)** |

(54) **Semiconductor device with pressure connection means.**

(57) According to the present invention, one surface of a resistor plate (7) is arranged to face first electrodes (4) which are formed on a first region of one surface of a semiconductor element assembly. One surface of a conductor plate (5) is arranged to face the other surface of the resistor plate (7). Pressure is applied to the other surfaces of the semiconductor element assembly and the conductor plate (5), to form junction surfaces between the first electrodes (4) and the resistor plate (7) as well as between the resistor plate (7) and the conductor plate (5) to connect them with pressure. This structure is equivalent to inserting resistors between the first electrodes (4) and the conductor plate (7). Such resistors uniformalize distributed or partial currents flowing in respective parts of the semiconductor element assembly, whereby any local current concentration can be prevented, to thereby improve switching characterizistics and controllable gate turn-off current.

$F I G . 3$

# SEMICONDUCTOR DEVICE

## Background of the Invention

### Field of the Invention

The present invention relates to a semiconductor device, and more particularly, it relates to a pressure-connection type semiconductor device such as a high-power gate turn off thyristor having a multi-emitter structure, for example.

### Description of the Background Art

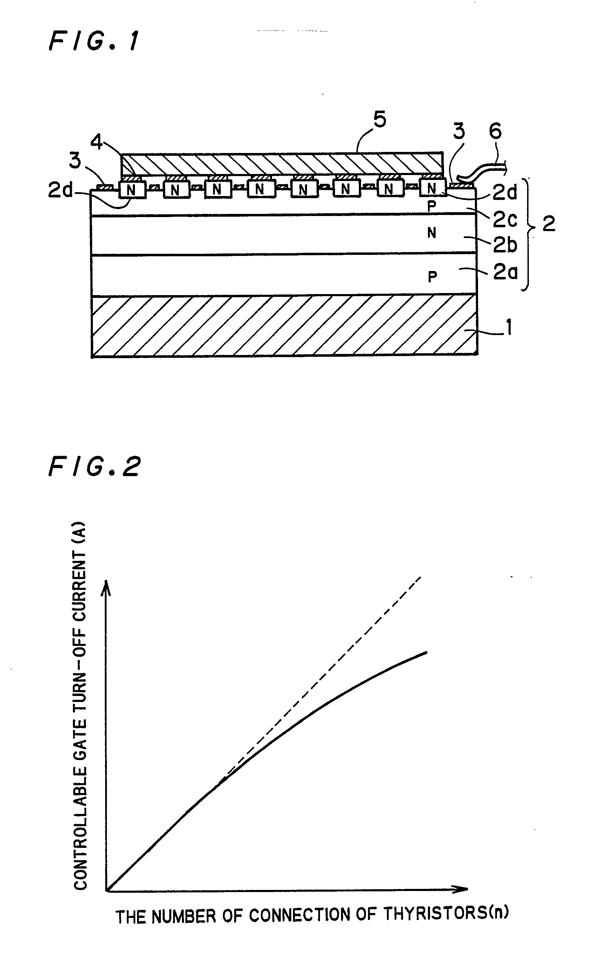

Japanese Patent Laying-Open Gazette No. 113278/1986 discloses a conventional semiconductor device of this type. Fig. 1 is a sectional view showing such a conventional semiconductor device.

Referring to Fig. 1, a P-type emitter layer 2a, an N-type base layer 2b and a P-type base layer 2c are formed in this order on the surface of an anode electrode 1, and a plurality of N-type emitter regions 2d are formed on an upper layer part of the P-type base layer 2c at regular intervals. Thus, a plurality of thyristors 2 are formed by the P-type emitter layer 2a, the N-type base layer 2b, the P-type base layer 2c and the N-type emitter regions 2d. Gate electrodes 3 are formed on the surface of the P-type base layer 2c, while cathode electrodes 4 are formed on the respective N-type emitter regions 2d.

A contact electrode plate 5 is pressed on the cathode electrodes 4 to be electrically in contact therewith in order to electrically connect the cathode electrodes 4 with each other. A gate lead wire 6 is electrically connected to the gate electrode 3. A gate turn-off thyristor (hereinafter referred to as "GTO") is formed by several hundreds to several thousands of such thyristors 2, each having capacity of several amperes, which are connected in parallel with each other.

The switching characteristic of the GTO formed in the aforementioned manner depends on the switching performance of each thyristor 2 and the balance performance among the switching characteristics of the respective thyristors 2. In order to obtain a GTO having an excellent switching characteristic, thyristors 2 of excellent switching performance must be connected in parallel with each other, with no dispersion in characteristic.

Particularly, a GTO has such a structure that a current concentration is easily caused at turn-off. Therefore, it is desired to reduce the current concentration of each respective thyristor 2 and to balance the switching characteristics of the thyristors 2 by uniformalizing the current distribution among the thyristors 2 which are connected in parallel with each other.

However, a conventional GTO is formed by merely connecting the thyristors 2 in parallel with each other as described above, and no means are provided to reduce the current concentration of each respective thyristor 2 and to make the current distribution among the thyristors 2 uniform.

Therefore, a current concentration at turn-off cannot be prevented in the conventional GTO, and it is difficult to balance the switching characteristics of all the respective thyristors 2, whereby the switching characteristics are lowered. Further, the following problem arises due to this lacking balance: If the switching characteristics of the respective thyristors 2 can be balanced, the controllable gate turn-off current (A) representing the turn-off performance of the $\overline{GTO}$ is proportional to the number (n) of connections of the thyristors 2, as shown by a broken line in Fig. 2.

In the aforementioned conventional GTO, however, the controllable gate turn-off current (A) is lower when compared with the theoretical $\overline{value}$ (broken line in Fig. 2) with an increasing number (n) of connections of the thyristors 2 as shown by a solid line in Fig. 2, since the thyristors 2 are not balanced in their switching characteristics. Thus, a GTO of high controllable gate turn-off current cannot be obtained even if the number of connections (n) of the thyristors 2 is increased.

Accordingly, the main object of the present invention is to provide a semiconductor device which has an excellent switching characteristics as well as a high controllable gate turn-off current.

## Summary of the Invention

A semiconductor device according to the present invention comprises a semiconductor element assembly having a plurality of semiconductor elements connected in parallel, a plurality of first electrodes arranged on one surface side of the semiconductor element assembly to be connected with the plurality of semiconductor elements, respectively, a resistor plate which is so arranged that its one surface faces the surfaces of the first electrodes, a conductor plate which is so arranged that its one surface faces the other surface of the resistor plate, and pressure connection means for applying pressure to the other surfaces of the semiconductor element assembly and the conductor plate to create junction surfaces between the first electrodes and the resistor plate as well as between the resistor plate and the conductor plate to connect them with pressure.

These and other objects, features, aspects and advantages of the present invention will become more apparent from the following detailed description of the present invention when taken in conjunction with the accompanying drawings.

Brief Description of the Drawings

Fig. 1 is a sectional view showing a conventional semiconductor device;

Fig. 2 illustrates the relation between the number of connections of thyristors and the controllable gate turn-off current in the device shown in Fig. 1;

Fig. 3 is a sectional view showing an embodiment of a semiconductor device according to the present invention; and

Fig. 4 is a circuit diagram showing an equivalent circuit of the semiconductor device shown in Fig. 3.

Description of a preferred Embodiment

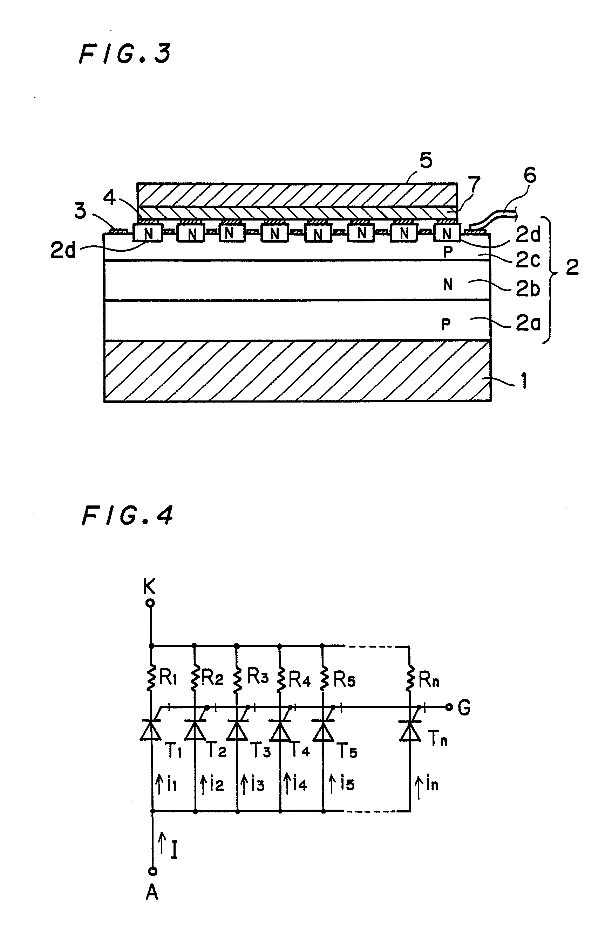

Fig. 3 is a sectional view showing a semiconductor device according to the present invention. Referring to Fig. 3, a P-type emitter layer 2a, an N-type base layer 2b and a P-type base layer 2c are formed in this order on the surface of an anode electrode 1, and a plurality of N-type emitter regions 2d are formed on an upper layer part of the P-type base layer 2c at regular intervals. Thus, a plurality of thyristors 2 are formed by the P-type emitter layer 2a, the N-type base layer 2b, the P-type base layer 2c and the N-type emitter regions 2d. Gate electrodes 3 are formed on the surface of the P-type base layer 2c. The gate electrodes 3 are electrically connected with each other, although such a connection is not shown in Fig. 3.

Cathode electrodes 4 are formed on the respective N-type emitter regions 2d. A thin resistor plate 7 of uniform thickness is arranged on the cathode electrodes 4, and a contact electrode plate 5 is arranged on the thin resistor plate 7. Pressure is applied to the contact electrode plate 5 and the anode electrode 1 by a well-known technique such as an insulated case, whereby the thin resistor plate 7 is pressed on and against the cathode electrodes 4 to be electrically in contact therewith in order to electrically connect all the cathode electrodes 4 with each other. Further, the contact electrode plate 5 is pressed against the thin resistor plate 7 to be electrically in contact therewith.

Fig. 4 is a circuit diagram showing an equivalent circuit of the semiconductor device shown in Fig. 3. As shown in Fig. 4, thyristors T1 to Tn are respectively connected in series with resistors R1 to Rn, and all these series circuits are connected in parallel with each other. The respective resistors R1 to Rn have resistance components of regions corresponding to the respective thyristors T1 to Tn within the thin resistor plate 7, and the respective resistors R1 to Rn are at the same value since the thin resistor plate 7 has a uniform thickness. Symbols K, A and G denote a cathode terminal, an anode terminal and a gate terminal, respectively.

If any current concentration is caused in the thyristor T1, for example, among the thyristors T1 to Tn when a GTO having the aforementioned structure is turned off, a distributed or partial current i1 is increased as compared with the other partial currents i2 to in. However, the following relation holds between a current I flowing across the anode and cathode temrinals A and K of the GTO and the distributed partial currents i1 to in:

$$I = i1 + i2 + i3 + ... + in \quad (1).$$

Since the resistors R1 to Rn are at the same value, a voltage drop $\Delta VR1$ developed across the resistor R1 is increased as compared with those $\Delta VR2$ to $\Delta VRn$ developed across the resistors R2 to Rn. The following relation holds between the voltage drop $\Delta VR1$ and the voltage drop $\Delta VR2$ to $\Delta VRn$:

$$\Delta VR1 + \Delta VT1 = \Delta VR2 + \Delta VT2 = .... = \Delta VRn + \Delta VTn \quad (2),$$

where $\Delta VTi$ (i = 1, 2, ..., n) represents a voltage drop across the thyristors Ti (i = 1, 2, ..., n) wherein the series circuits formed by the thyristors Ti and the resistors Ri (i = 1, 2, ..., n) are connected in parallel with each other, as shown in Fig. 4. In the case where the voltage drop $\Delta VR1$ is increased as compared with the voltage drop $\Delta VR2$ to $\Delta VRn$, the voltage drop $\Delta VT1$ is decreased as compared with the voltage drop $\Delta VT2$ to $\Delta VTn$ as equation (2) is satisfied, and a current across the thyristor T1 is decreased, accordingly.

Consequently, the resistor R1 suppresses the current i1 to balance the currents i1 to in, while current re-distribution is performed with respect to the currents i2 to in. In other words, the resistors R1 to Rn so uniformalize the distributed or partial currents i1 to in as to prevent any local current concentration. Therefore, the respective thyristors 2 can be balanced in switching characteristic, to thereby improve the switching characteristic of the GTO. Thus, the controllable gate turn-off current (A) approaches the theoretical value (broken line in Fig. 2), whereby a GTO of high gate turn-off capacity can be obtained by increasing the number (n) of connections of the thyristor 2.

Although the above embodiment has been described with reference to a reverse-blocking type gate turn-off thyristor having a PNPN structure, the present invention is also applicable to a reverse-conductivity type gate turn-off thyristor having a shorted emitter at its anode side, a reverse-blocking type or a reverse-conductivity type gate turn-off thyristor having an NPNP structure or another multi-emitter semiconductor device employing a pressure-contact structure such as a high-power transistor or a high-power electrostatic induction thyristor, to attain a similar effect of improving the switching characteristic of such a semiconductor device.

Although the present invention has been described and illustrated in detail, it is clearly understood that the same is by way of illustration and example only and is not to be taken by way of limitation, the spirit and scope of the present invention being limited only by the terms of the appended claims.

## Claims

1. A semiconductor device comprising:
-a semiconductor element assembly having a plurality of semiconductor elements (2) connected in parallel,
-a plurality of first electrodes (4) being arranged on one surface side of the semiconductor element assembly to be connected with the plurality of semiconductor elements (2), respectively,
-a resistor plate (7) being so arranged that its one surface faces the surfaces of the first electrodes (4),
-a conductor plate (5) being so arranged that its one surface faces the other surface of the resistor plate (7),
-pressure connection means for applying pressure to the other surfaces of the semiconductor element assembly and conductor plate (5) to create junction surfaces between the first electrodes (4) and the resistor plate (7) as well as between the resistor plate (7) and the conductor plate (5) when connecting them by pressure.

2. The semiconductor device in accordance with claim 1, wherein the semiconductor element assembly is a gate turn-off thyristor.

3. The semiconductor device in accordance with claim 1, wherein the semiconductor element assembly is an electrostatic induction type thyristor.

4. The semiconductor device in accordance with any of claims 1 to 3, wherein the resistor plate (7) is a thin plate having a uniform thickness.

*FIG.1*

*FIG.2*

CONTROLLABLE GATE TURN-OFF CURRENT (A)

THE NUMBER OF CONNECTION OF THYRISTORS(n)

FIG.3

FIG.4